# EUROPÄISCHE PATENTSCHRIFT

(11) **EP 2 850 924 B1**
(45) Veröffentlichungstag und Bekanntmachung des Hinweises auf die Patenterteilung: **20.03.2019**
(21) Anmeldenummer: 13727799.2
(22) Anmeldetag: 07.05.2013
(51) Int. Cl.: H05K 5/02, B65D 90/00, G01S 19/35, H05K 5/00

(54) **MODULARES GEHÄUSESYSTEM**
MODULAR HOUSING SYSTEM
SYSTÈME DE BOÎTIER MODULAIRE

(30) Priorität: 16.05.2012 DE 102012104272
(43) Veröffentlichungstag der Anmeldung: 25.03.2015
(73) Patentinhaber: Mecomo AG, 85716 Unterschleißheim (DE)
(72) Erfinder: HEIMERL, Stefan, 84034 Landshut (DE)
(74) Vertreter: Kindermann, Peter
(86) Internationale Anmeldenummer: PCT/DE2013/100169
(87) Internationale Veröffentlichungsnummer: WO 2013/170851

(56) Entgegenhaltungen:
- WO-A1-2011/018282
- DE-A1-102005 021 502
- DE-B- 1 139 998
- US-A1- 2003 082 955
- US-B1- 7 450 083

## Beschreibung

Die vorliegende Erfindung bezieht sich auf ein modulares Gehäusesystem zur Aufnahme von elektronischen Schaltungen und insbesondere auf ein modulares Gehäusesystem für Telematikeinheiten.

Unter dem Begriff Telematik wird nachfolgend insbesondere eine Technologie verstanden, die im Bereich der Sicherheitstechnik, des Flottenmanagements, der Logistik und dem Fernwirken zum Einsatz kommt und insbesondere Mittel der Telekommunikation und der Informatik miteinander verknüpft. Telematikeinheiten können beispielsweise eine Ortsbestimmungseinheit sowie eine Telekommunikationseinheit zum Übertragen der erfassten Ortsdaten an eine in einem Kommunikationsnetzwerk vorhandene Recheneinheit bzw. Datenverarbeitungseinheit aufweisen.

Beispielsweise werden zur Überwachung von Transportcontainern diese üblicherweise mit mobilen Telematikeinheiten versehen. Hierbei kann beispielsweise eine aktuelle Position des mit der Telematikeinheit bestückten Transportcontainers mittels eines Mobilfunkschnittstellen-Moduls oder eines GPS-Moduls erfasst und an die zentrale Datenverarbeitungseinheit übermittelt werden. Ferner kann die Telematikeinheit Sensoren aufweisen, welche Zustandsdaten des Transportcontainers oder dessen Inhalts erfassen, wobei die Zustandsdaten lokal in einem Datenspeicher abgelegt und/oder an die zentrale Datenverarbeitungseinheit übermittelt werden können. Ferner kann ein Auswertemodul zum Auswerten der erfassten Daten in der Telematikeinheit vorgesehen sein. Zum Betreiben der verschiedenen elektronischen Schaltungsmodule besitzt die Telematikeinheit ferner eine Energieversorgungseinheit, die beispielsweise durch eine Batterie, einen Akkumulator oder ein Solarpanel realisiert wird.

Derartige Telematikeinheiten können folglich eine Vielzahl von unterschiedlichen Schaltungsmodulen aufweisen, die je nach Einsatzgebiet unterschiedlich kombiniert und am Transportcontainer angebracht werden müssen.

Aus der Druckschrift WO 2011/018282 A1 ist eine Aufnahmevorrichtung für eine modulare Telematikeinheit bekannt, wobei in eine Halteschiene zumindest ein Gehäuse für die Schaltungsmodule sowie ein Solarpanel eingeschoben werden können. Eine Erweiterung der Telematikeinheit ist folglich nur in Richtung der Halteschiene möglich.

Aus der Druckschrift US 2003/0082955 A1 ist ein modulares Gehäusesystem zur Aufnahme von elektronischen Schaltungen bekannt, mit zumindest einem Grundgehäusemodul, welches zwei gegenüberliegende Stirnflächen aufweist, wobei an der ersten Stirnfläche in einer ersten Ebene eine erste Verbindungsplatte und in einer davon verschiedenen zweiten Ebene eine zweite Verbindungsplatte ausgebildet sind. Hierbei sind an der zweiten Stirnfläche in der ersten Ebene eine dritte Verbindungsplatte und in der zweiten Ebene eine vierte Verbindungsplatte ausgebildet. Ferner weisen die Verbindungsplatten jeweils zumindest eine Öffnung auf, in die jeweils ein Verriegelungselement einführbar ist, so dass eine Vielzahl von Grundgehäusemodulen in vertikaler Richtung miteinander verbunden werden können.

Ferner offenbart die Druckschrift DE 11 39 998 B eine modulare Halterung für einen nullstellbaren Impulszähler, wobei die Stirnflächen und Seitenflächen derart mit Leisten und Nuten ausgestaltet sind, so dass eine Vielzahl von Halterungen in horizontaler Richtung miteinander verbunden werden können.

Demgegenüber liegt der Erfindung die Aufgabe zugrunde, ein modulares Gehäusesystem zur Aufnahme von elektronischen Schaltungen zu schaffen, welches eine erhöhte Flexibilität aufweist.

Erfindungsgemäß wird diese Aufgabe durch die Merkmale des Patentanspruchs 1 gelöst.

Erfindungsgemäß weist ein modulares Gehäusesystem zur Aufnahme von elektronischen Schaltungen zumindest ein Grundgehäusemodul auf, welches zwei gegenüberliegende Stirnflächen aufweist, wobei an der ersten Stirnfläche in einer ersten Ebene eine erste Verbindungsplatte und in einer zweiten von der ersten Ebene unterschiedlichen Ebene eine zweite Verbindungsplatte ausgebildet sind, wobei an der zweiten Stirnfläche in der ersten Ebene eine dritte Verbindungsplatte und in der zweiten Ebene eine vierte Verbindungsplatte ausgebildet sind, wobei jeweils die erste und dritte Verbindungsplatte sowie die zweite und vierte Verbindungsplatte an ihren Stirnflächen derart ausgeformt sind, dass die dritte und vierte Verbindungsplatte entsprechend invertierte Formen zu der ersten und zweiten Verbindungsplatte aufweisen, und wobei die erste und vierte Verbindungsplatte jeweils zumindest eine Öffnung aufweisen, in die jeweils ein Verriegelungselement einführbar ist, so dass eine Vielzahl von Grundgehäusemodulen in vertikaler Richtung oder in horizontaler Richtung Form stabil und exakt miteinander verbunden werden können. Das erfindungsgemäße Gehäusesystem besitzt somit eine erhöhte Flexibilität, da es 2-dimensional kombinierbar und erweiterbar ist, d.h. in vertikaler und in horizontaler Richtung. Das Gehäusesystem ist dadurch sowohl stapelbar als auch in beide Richtungen verlängerbar. Gleichzeitig wird eine sehr robuste und verwindungssteife Verbindung untereinander realisiert.

Vorzugsweise können die erste und vierte Verbindungsplatte jeweils eine konvexe Form und die zweite und dritte Verbindungsplatte jeweils eine konkave Form aufweisen, wodurch sich beim Zusammenfügen ein selbst-justierendes System ergibt, welches darüber hinaus verbesserte mechanische Eigenschaften und insbesondere eine erhöhte Verwindungssteifigkeit aufweist.

Beispielsweise kann an den Stirnflächen des Grundgehäusemoduls zumindest ein Durchlass zur Realisierung einer elektrischen Steckverbindung und/oder eines Kabeldurchlasses zwischen benachbarten Grundgehäusemodulen vorgesehen sein, wodurch eine Erweiterung auch hinsichtlich der elektrischen Leitungen sehr einfach ermöglicht ist.

Vorzugsweise können die erste und zweite Verbindungsplatte sowie die dritte und vierte Verbindungsplatte unmittelbar übereinander angeordnet sein, wodurch sich bei der Montage ein vereinfachtes Zusammenfügen (Modul schräg an Verbindungsstelle anstellen und herunterklappen) ergibt.

Vorzugsweise kann das Verriegelungselement eine Steckachse mit kreisrundem, ovalem oder mehreckigem Querschnitt darstellen. Dadurch können einerseits die Kosten für das Gehäusesystem und andererseits der Montageaufwand beim Aufbau vor Ort wesentlich verringert werden.

Ferner kann ein Gehäusedeckel vorgesehen sein, der das Gehäusemodul abdeckt, wobei der Gehäusedeckel an seinen Stirnflächen jeweils nur eine Verbindungsplatte aufweist, die hinsichtlich ihrer Form der zweiten und vierten Verbindungsplatte entspricht. Die im Gehäusemodul angeordneten Bauteile könen dadurch wasser- und staubdicht verpackt werden.

Hierbei kann das Grundgehäusemodul an seinen Seitenflächen zumindest eine erste Aussparung und der Gehäusedeckel zumindest eine zugehörige Klemmlasche aufweisen, wobei durch Eingreifen der zumindest einen Klemmlasche in die zumindest eine Aussparung des Grundgehäusemoduls der Gehäusedeckel auf dem Grundgehäusemodul befestigt werden kann. Das Öffnen und Schließen des Gehäusemoduls wird dadurch wesentlich erleichtert.

Ferner kann ein Rahmenmodul zur Aufnahme eines flächigen Elektronikbauteils vorgesehen sein, wobei das Rahmenmodul an seinen Stirnflächen jeweils zwei Verbindungsplatten aufweist, die hinsichtlich ihrer Form der ersten bis vierten Verbindungsplatte entsprechen. Dadurch können die im Gehäusemodul untergebrachten Bauteile sehr einfach mit beispielsweise Ausgabeeinheiten und/oder Eingabeeinheiten ergänzt werden.

Hierbei kann das Grundgehäusemodul an seinen Seitenflächen ferner zumindest eine zweite Aussparung aufweisen und das Rahmenmodul zumindest eine zugehörige Klemmlasche aufweisen, wobei durch Eingreifen der zumindest einen Klemmlasche in die zumindest eine zweite Aussparung des Grundgehäusemoduls das Rahmenmodul auf dem Grundgehäusemodul befestigt wird. Eine Montage wird dadurch weiterhin erleichtert.

Vorzugsweise kann das flächige Elektronikbauteil ein Solarpanel aufweisen, wobei das Rahmenmodul ferner Belüftungsschlitze zum Belüften des Solarpanels und zur thermischen Entkopplung der weiteren Module aufweist. Auf diese Weise kann eine autarke Energieversorgung und gleichzeitig eine zuverlässige Kühlung der Solarpanele sichergestellt werden.

Ferner kann ein Abdeckmodul, insbesondere eine Plexiglasscheibe, zur Realisierung eines mechanischen Schutzes vorgesehen sein, das zumindest zwei Öffnungen aufweist, in die jeweils das Verriegelungselement einführbar ist. Ein zusätzlicher Vandalismusschutz kann dadurch optional und sehr einfach an dem bereits montierten Gehäusesystem angebracht werden.

Ferner kann ein Befestigungsmodul zur Realisierung einer Befestigung des Gehäusesystems auf einem Untergrund vorgesehen sein, das zumindest zwei Öffnungen aufweist, in die jeweils das Verriegelungselement einführbar ist. Dadurch erhält man eine flexible und einfache Befestigungsmöglichkeit für das erfindungsgemäße Gehäusesystem.

Vorzugsweise weist das Befestigungsmodul an seinen Stirnflächen jeweils zwei Verbindungsplatten auf, die hinsichtlich ihrer Form der ersten bis vierten Verbindungsplatte entsprechen. Dadurch können auch eine Vielzahl von Befestigungsmodulen ineinander gesteckt werden, wodurch sich eine Gesamtlänge der Befestigung beliebig einstellen lässt.

Beispielsweise kann das Befestigungsmodul Näherungssensoren zum Erfassen einer Anwesenheit des Untergrunds und lösbare Befestigungselemente zum lösbaren Befestigen des Befestigungsmoduls auf dem Untergrund aufweisen. Dadurch kann einerseits ein Diebstahlschutz und andererseits eine schnelle Montage realisiert werden.

Vorzugsweise ist das Befestigunsmodul in vier Quadranten aufgeteilt, wobei in einem vorbestimmten Quadranten alle Befestigungselemente angeordnet sind. Hierdurch kann eine überlappende Montage z.B. an Transportcontainertüren ermöglicht werden, die weiterhin das Öffnen uns Schließen der Türen ermöglicht.

Hierbei können in dem vorbestimmten Quadranten zumindest zwei Näherungssensoren und in dem punktsymmetrisch gegenüberliegenden Quadranten zumindest ein Näherungssensor angeordnet sein, wodurch man neben einer zuverlässigen Diebstahlüberwachung für das Gehäusesystem ferner eine Türüberwachung realisieren kann.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
Figur 1 eine vereinfachte Draufsicht eines Grundgehäusemoduls gemäß eines ersten Ausführungsbeispiels;
Figuren 2 und 3 vereinfachte perspektivische Ansichten des Grundgehäusemoduls gemäß Figur 1 mit Gehäusedeckel;
Figur 4 eine vereinfachte perspektivische Ansicht eines Rahmenmoduls;
Figur 5 eine vereinfachte Draufsicht eines Befestigungsmoduls;
Figur 6 eine vereinfachte perspektivische Ansicht eines modularen Gehäusesystems gemäß eines weiteren Ausführungsbeispiels; und
Figur 7 eine vereinfachte perspektivische Ansicht eines modularen Gehäusesystems gemäß eines weiteren Ausführungsbeispiels.

Die vorliegende Erfindung umfasst insbesondere ein modulares Gehäusesystem für Telematikeinheiten, deren einzelne Module in der Art eines Baukastensystems auf einfache und flexible Weise miteinander verknüpft werden können.

Das Gehäusesystem kann beispielsweise an der Oberseite, an der Seite oder an den Türen eines so genannten Transportcontainers sowohl innen als auch außen angebracht werden. Vorzugsweise ermöglicht das Gehäusesystem eine modulare Verlängerung oder Stappelung in den rillenförmigen Vertiefungen bzw. Sicken eines Transportcontainers oder einer so genannten Wechselbrücke, obwohl das Gehäusesystem auch ohne das Vorhandensein von Vertiefungen montierbar ist.

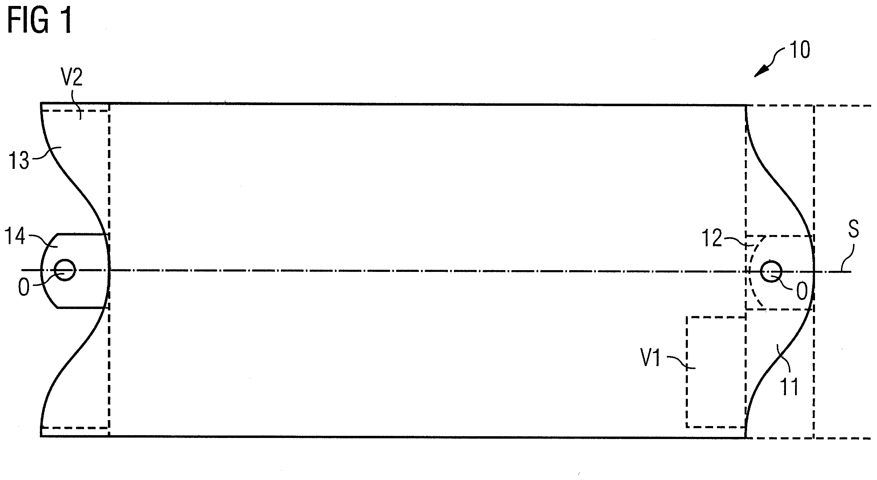

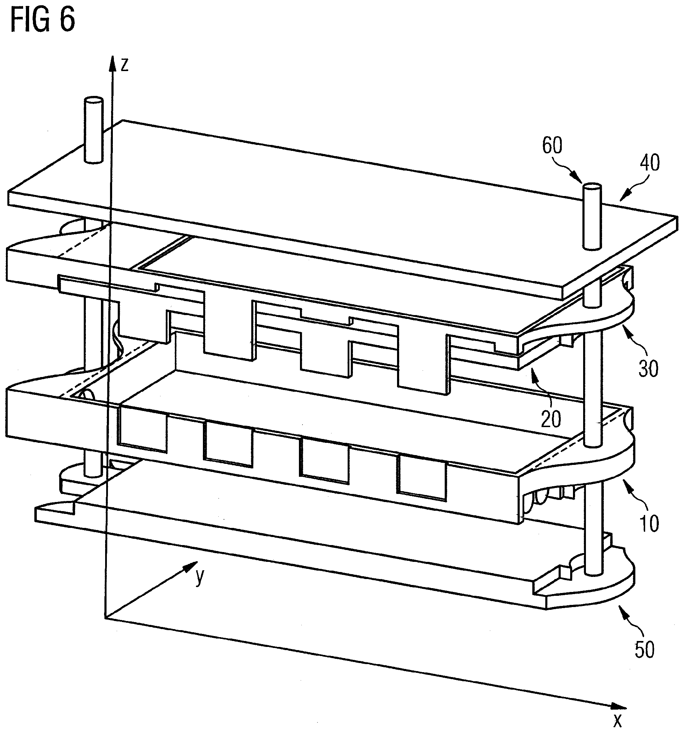

Die Figuren 1 und 6 zeigen eine vereinfachte Draufsicht eines Grundgehäusemoduls 10 sowie die Verwendung eines derartigen Grundgehäusemoduls 10 in einem modularen Gehäusesystem gemäß eines ersten Ausführungsbeispiels der vorliegenden Erfindung.

Gemäß Figur 1 kann das Grundgehäusemodul 10 einen im Wesentlichen quaderförmigen Gehäusekörper aufweisen, in dem (nicht dargestellte) elektronische Bauteile oder Schaltungen und insbesondere Telematikeinheiten angeordnet sein können. Dies können beispielsweise ein Akkumulator oder eine Batterie zur Energieversorgung, ein GPS-Modul (Global Positioning System) zur Erfassung von Ortsdaten, Sensoren zur Erfassung von Zustandsdaten des Transportcontainers, dessen Inhalts oder des Gehäusesystems, eine Auswerteeinheit zum Auswerten der erfassten Daten und/oder ein Funk-Modul, wie beispielsweise ein GSM-Modul, zur Anbindung an eine zentrale Datenverarbeitungseinheit über z.B. ein Mobilfunknetz sein. Ferner können beliebige weitere elektronische Schaltungen auf Schaltungsplatinen realisiert sein, welche in dem Grundgehäusemodul 10 angeordnet sein können.

Das Grundgehäusemodul 10 kann beispielsweise eine Höhe von 1cm bis 3cm und eine Breite von 6cm bis 13cm aufweisen. Die Länge des Grundkörpers ist grundsätzlich frei wählbar, wobei beispielsweise eine Länge von 10cm bis 35cm verwendet wird. Vorzugsweise weist das Grundgehäusemodul 10 eine Höhe von ca. 2,5cm, eine Breite von ca. 9cm und eine Länge von ca. 20cm aufweisen. Das Grundgehäusemodul 10 kann eine Materialstärke für den Boden- und Wandbereich von beispielsweise 2mm bis 5mm aufweisen und besteht beispielsweise aus elektrisch nicht leitendem Material, um einen Signalempfang des Funkmoduls oder des GPS-Moduls nicht zu beeinträchtigen. Beispielsweise wird ein mechanisch hochfester und temperaturbeständiger Kunststoff verwendet, welcher ferner gegenüber Sonneneinstrahlung stabil ist. Dadurch kann sichergestellt werden, dass er den unterschiedlichsten Umwelteinflüssen zuverlässig stand hält.

Alternativ oder zusätzlich kann das Grundgehäusemodul 10 jedoch auch aus einem elektrisch leitfähigen Material wie z.B. Aluminium bestehen, oder mit elektrisch leitfähigem Material beschichtet sein, wodurch HF-empfindliche Schaltungsmodule gezielt vor elektromagnetischen Störeinflüssen abgeschirmt werden können.

Vorzugsweise weist das im Wesentlichen quaderförmige Grundgehäusemodul 10 eine an die rillenförmigen Vertiefung bzw. Sicke des Transportcontainers oder der Wechselbrücke angepasste Form auf. Da derartige rillenförmige Vertiefungen bzw. Sicken des Transportcontainers oder der Wechselbrücke hinsichtlich ihres Querschnitts trapezförmig ausgestaltet sind, kann demzufolge auch das Grundgehäusemodul 10 bzw. das gesamte Gehäusesystem einen an die rillenförmige Vertiefungen bzw. Sicken angepassten trapezförmigen Querschnitt aufweisen. Die Seitenwände können demzufolge nicht nur in einem rechten Winkel sondern schräg nach außen, d.h. nach außen verbreiternd, ausgestaltet sein. Dadurch kann auch bei kleinem "Footprint" bzw. Bodenmaß ein maximaler Innenraum für jeweilige Bauteile bereitgestellt werden.

Gemäß Figur 1 weist das im Wesentlichen quaderförmige Grundgehäusemodul 10 an seinen gegenüberliegenden Stirnflächen jeweils zwei Verbindungsplatten 11 und 12 sowie 13 und 14 auf, die jeweils in unterschiedlichen Ebenen ausgebildet sind. Wie in Figur 6 dargestellt ist, kann eine erste Verbindungsplatte 11 beispielsweise in der oberen Hälfte der Stirnfläche ausgebildet sein, währen die zweite Verbindungsplatte 12 in der unteren Hälfte der Stirnfläche ausgebildet ist. Die erste und zweite Verbindungsplatte 11 und 12 können hierbei jeweils eine Dicke aufweisen, die gemeinsam einer Höhe des Grundgehäusemoduls entspricht, wodurch sichergestellt werden kann, dass die Verbindungsplatten unmittelbar übereinander angeordnet werden können. Vorzugsweise liegt folglich kein Zwischenraum zwischen den Verbindungsplatten vor, sondern die jeweiligen Verbindungsplatten berühren sich unmittelbar. Für den Fall, dass mehrere Grundgehäusemodule übereinander gestapelt werden, sind auch die Verbindungsplatten der gestapelten Module unmittelbar übereinander angeordnet. Dies ermöglicht eine schnelle und einfache Montage, wobei in vertikaler Richtung (z-Richtung) eine spielfreie Befestigung realisiert wird.

Hinsichtlich ihrer Draufsicht kann die erste Verbindungsplatte 11 gemäß Figur 1 im Wesentlichen eine konvexe Form aufweisen, die halbkreisförmig aus der Stirnfläche herausragt und sich zu den Seitenflächen des Grundgehäusemoduls 10 hin asymptotisch annähert. Demgegenüber kann die zweite Verbindungsplatte 12 einen Vorsprung darstellen, dessen Stirnfläche eine konkave Form aufweist. Beispielsweise weist die erste Verbindungsplatte zumindest eine Öffnung O auf, in die zumindest ein Verriegelungselement 60 einführbar ist. Gemäß Figur 1 kann genau eine Öffnung O in der ersten Verbindungsplatte 11 derart ausgebildet sein, dass sie im Wesentlichen auf der Symmetrieachse S des Grundgehäusemoduls 10 liegt. Ferner kann die zweite Verbindungsplatte 12 derart ausgebildet sein, dass sie von der Öffnung O ausreichend beabstandet ist. Vorzugsweise kann die Öffnung O derart ausgebildet sein, dass sie auf der Symmetrieachse S auf halber Strecke zwischen den Stirnflächen der ersten und zweiten Verbindungsplatten 11 und 12 liegt. Obwohl die zweite Verbindungsplatte 12 grundsätzlich wie die erste Verbindungsplatte 11 über die gesamte Breite der Stirnfläche des Grundgehäusemoduls 10 ausgeformt sein kann, besitzt sie vorzugsweise eine geringere Breite als das Grundgehäusemodul 10, wodurch seitlich von ihr die Möglichkeit für Kontakt- und Durchlassöffnungen D in längsrichtung bereitgestellt wird. Insbesondere können so genannte Vertiefungen V1 seitlich neben der zweiten Verbindungsplatte 12 ausgebildet sein, in der zumindest ein Durchlass D ausgebildet sein kann, welcher wiederum einen Kabeldurchlass oder eine Steckverbindung zwischen benachbarten Modulen ermöglicht. Vorzugsweise erfüllt der Durchlass D hierbei die Schutzklasse IP69k.

Gemäß Figur 1 weist das Grundgehäusemodul 10 an seiner gegenüberliegenden Stirnfläche eine dritte und vierte Verbindungsplatte 13 und 14 auf, welche jeweils in der gleichen Ebene ausgebildet sind, wie die erste und zweite Verbindungsplatte 11 und 12 und an ihren Stirnflächen derart ausgeformt sind, dass sie mit den Stirnflächen der ersten und zweiten Verbindungsplatten 11 und 12 zumindest teilweise einen Formschluss realisieren. Genauer gesagt weist die dritte Verbindungsplatte 13 eine konkave Form auf, die genau der ersten Verbindungsplatte 11 entspricht, während die vierte Verbindungsplatte 14 eine konvexe Form aufweist, die genau der zweiten Verbindungsplatte 12 entspricht. Eine weitere Öffnung O ist hierbei in der vierten Verbindungsplatte 14 derart ausgebildet, dass nach dem Zusammenfügen von zwei erfindungsgemäßen Grundgehäusemodulen 10 und nach dem Verriegeln durch Einführen eines Verriegelungselements 60, eine in vertikaler und in horizontaler Richtung spielfreie Verbindung realisiert werden kann.

Hierfür weisen die dritte und vierte Verbindungsplatte 13 und 14 entsprechend invertierte Formen zu der ersten und zweiten Verbindungsplatte 11 und 12 auf. Wiederum kann auch an der zweiten Stirnfläche eine (nicht dargestellte) Vertiefung und insbesondere ein oder mehrere Durchlässe D zur Realisierung einer elektrischen Steckverbindung und/oder eines Kabeldurchlasses ausgebildet sein. Vorzugsweise kann durch Verlängerung der Seitenwände des Grundgehäusemoduls 10 im Kopplungsbereich ein nahtloser Übergang zwischen den angrenzenden Modulen bei horizontaler Verlängerung erreicht werden. Dadurch können insbesondere Kabel bzw. empfindliche Elemente (wie z.B. Sensoren) im Kopplungsbereich geschützt werden.

Das Verriegelungselement 60 kann beispielsweise als Steckachse mit kreisrundem Querschnitt ausgebildet sein. Alternativ können jedoch auch Steckachsen mit ovalem oder mehreckigem Querschnitt verwendet werden. Vorzugsweise können metallische Steckachsen verwendet werden, welche eine besonders hohe mechanische Festigkeit aufweisen. Alternativ können jedoch auch Steckachsen aus anderen Materialien und insbesondere aus Kunststoff verwendet werden. Obwohl in den Figuren immer nur eine Steckachse pro Verbindungsbereich dargestellt ist, können auch zwei oder mehr Steckachsen bzw. Verriegelungselemente 60 pro Verbindungsbereich verwendet werden.

Auf diese Weise können eine Vielzahl von Grundgehäusemodulen 10 in gestapelter oder verlängerter Form stabil und exakt miteinander verbunden werden. Zusätzlich können über (nicht dargestellte) Fixierpunkte an den Ecken der Grundgehäusemodule 10 die vertikalen Verbindungen (gestapelt) unterstützt werden. Durch die Verwendung der erfindungsgemäßen halbrunden Formteile für die Verbindungsplatten 11 bis 14 an beiden Stirnflächen des Grundgehäusemoduls 10 erhält man eine passgenaue und in horizontaler (x-) Richtung verwindungssteifen Verbindung. Die Robustheit und Montagefreundlichkeit des Gehäusesystems wird dadurch wesentlich erhöht.

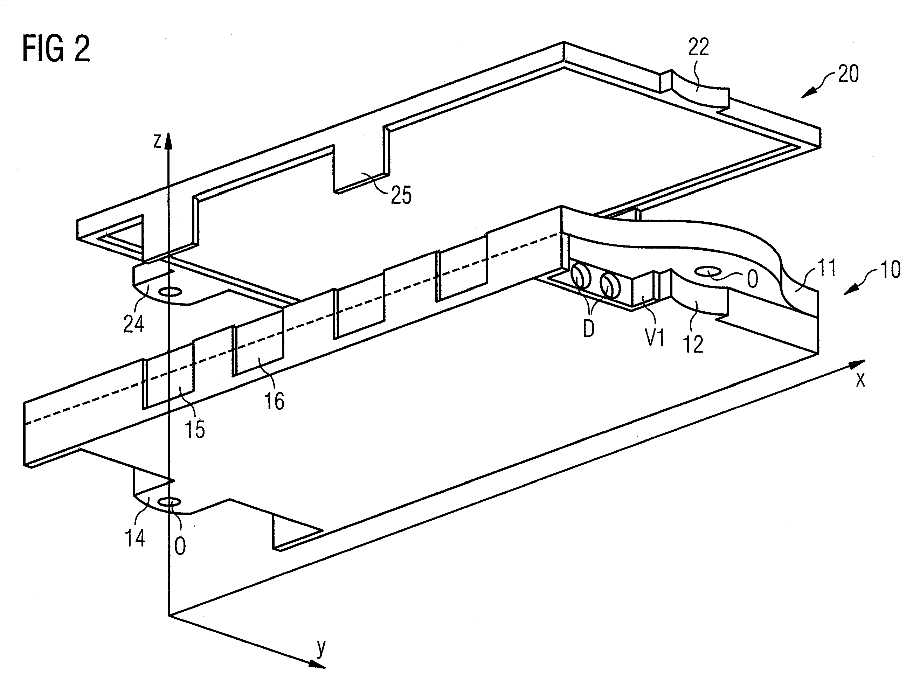

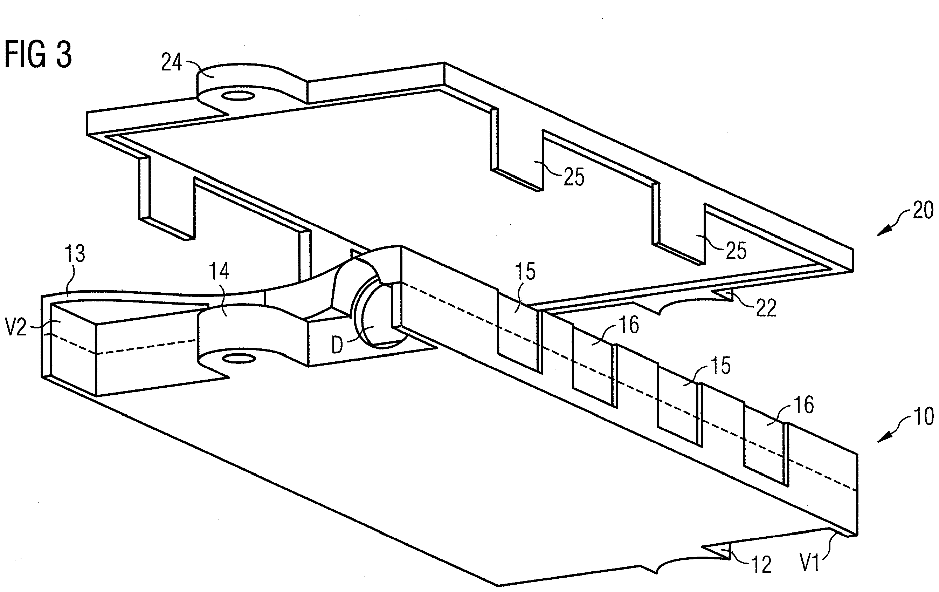

Die Figuren 2 und 3 zeigen vereinfachte perspektivische Ansichten des Grundgehäusemoduls 10 mit einem zugehörigen Gehäusedeckel 20, insbesondere zur Veranschaulichung der Details an den vorderen und hinteren Stirnflächen des Grundgehäusemoduls 10.

Gemäß Figur 2 können demzufolge in der vorstehend beschriebenen Gehäusevertiefung V1, welche zumindest an einer Seite der zweiten Verbindungsplatte 12 in der vorderen Stirnfläche des Grundgehäusemoduls 10 ausgebildet ist, zwei Durchlässe D ausgeformt sein. Dies ermöglicht beispielsweise eine elektrische Steckverbindung und/oder eine Kabelanbindung einerseits zu einem in x-oder z-Richtung angestecktem weiteren Grundgehäusemodul oder sonstigen Modul (nicht dargestellt).

Gemäß Figur 3 kann jedoch an der hinteren Stirnfläche des Grundgehäusemoduls 10 seitlich neben der vierten Verbindungsplatte 14 auch nur ein Durchlass D ausgebildet sein, der jedoch derartige Abmessungen aufweist, dass er auch in die dritte Verbindungsplatte 13 eindringt. In ähnlicher Weise zu der im Grundgehäusemodul 10 ausgebildeten Vertiefung V1, kann auch in der dritten Verbindungsplatte 13 eine weitere Vertiefung V2 ausgebildet sein, welche im zusammengefügten Zustand der Module einen zumindest teilweise abgeschlossenen Hohlraum für eine geschützte Steck- oder Kabelverbindung ermöglicht. Zur Realisierung einer vertikalen Steck- oder Kabelverbindung können die ersten und dritten Verbindungsplatten ebenfalls Durchlassöffnungen oder Aussparungen (nicht dargestellt) aufweisen. In ähnlicher Weise können auch der Boden und/oder die Seiten des Grundgehäusemoduls 10 Durchlassöffnungen oder Aussparungen (nicht dargestellt) aufweisen, wodurch insbesondere Kabelverbindungen zwischen Modulen ermöglicht werden.

Die Figuren 2 und 3 zeigen ferner einen Gehäusedeckel 20 für das Grundgehäusemodul 10, welcher eine wasser- und/oder luftdichte Abdeckung des nach oben geöffneten Grundgehäusemoduls 10 ermöglichen kann. Die im Grundgehäusemodul 10 angeordneten elektronischen Schaltungen bzw. Baueinheiten können dadurch zuverlässig vor unerwünschten Umwelteinflüssen (Regen, Schnee, Staub usw.) geschützt werden. Vorzugsweise können sich hierbei (nicht dargestellte) Dichtungen zwischen Grundgehäusemodul 10 und Gehäusedeckel 20 sowie an den Durchlässen D befinden.

Ferner können an den Seitenflächen des Grundgehäusemoduls 10 erste Aussparungen 15 ausgebildet sein, welche im Zusammenspiel mit am Gehäusedeckel 20 ausgebildeten Klemmlaschen 25 eine schnelle Befestigung des Gehäusedeckels 20 am Grundgehäusemodul 10 ermöglichen. Die Klemmlaschen 25 sowie die zugehörigen ersten Aussparungen 15 können ferner einen Rastmechanismus aufweisen, der ein unbeabsichtigtes Ablösen des Gehäusedeckels in z-Richtung zuverlässig verhindert. Alternativ oder zusätzlich kann der Gehäusedeckel 20 auch mit dem Grundgehäusemodul 10 verschraubt oder anderweitig fixiert sein.

Gemäß Figuren 2 und 3 kann auch der Gehäusedeckel 20 Verbindungsplatten 22 und 24 aufweisen, die hinsichtlich ihrer Form der zweiten und vierten Verbindungsplatte 12 und 14 des Grundgehäusemoduls 10 entsprechen. Im zusammengefügten Zustand ergibt sich damit an den Stirnflächen eine SandwichStruktur für die Verbindungsplatten, bei der jeweils eine großflächige Verbindungsplatte 11 und 13 zwischen zwei kleinflächigen Verbindungsplatten 12 und 14 sowie 22 und 24 angeordnet ist. Der Gehäusedeckel 20 wird demzufolge zusätzlich durch das in die Öffnung O geschobene Verriegelungselement 60 und den Formschluss seiner korrespondierenden Verbindungsplatten 22 und 24 gesichert, wodurch sich weiterhin eine passgenaue und verwindungssteife Verbindung ergibt.

Vorzugsweise besitzt der Gehäusedeckel 20 die gleiche Breite und gleiche Länge wie das Grundgehäusemodul 10, wobei seine Höhe vorzugsweise der Dicke des Wand- bzw. Bodenmaterials des Grundgehäusemoduls 10 entspricht. In gleicher Weise können auch die gleichen Materialien wie für das Grundgehäusemodul 10 verwendet werden.

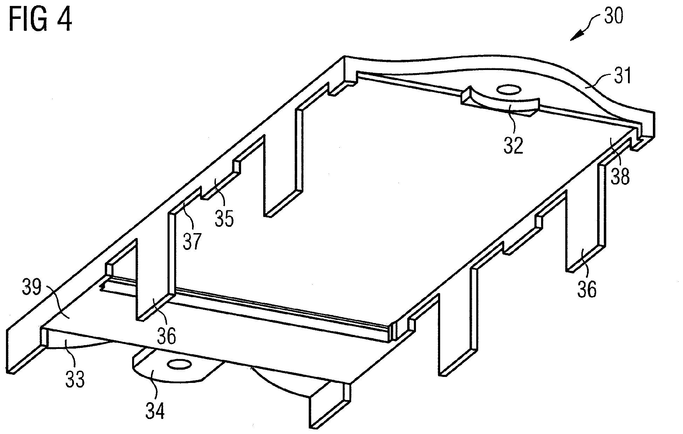

Weiterhin können an den Seitenflächen des Grundgehäusemoduls 10 zweite Aussparungen 16 ausgebildet sein, welche im Zusammenspiel mit an einem Rahmenmodul 30 (siehe Figuren 4 und 6) ausgebildeten Klemmlaschen 36 wiederum eine schnelle Befestigung des Rahmenmoduls 30 am Grundgehäusemodul 10 ermöglichen. Die Klemmlaschen 36 sowie die zugehörigen zweiten Aussparungen 16 können wiederum einen Rastmechanismus aufweisen, der ein unbeabsichtigtes Ablösen des Rahmenmoduls 30 in z-Richtung zuverlässig verhindert. Alternativ oder zusätzlich kann auch das Rahmenmodul 30 mit dem Grundgehäusemodul 10 bzw. dem Gehäusedeckel 20 verschraubt sein.

Das Rahmenmodul 30 kann gemäß Figur 4 beispielsweise einen Rahmen zur Aufnahme eines flächigen Elektronikbauteils 38 aufweisen. Wiederum kann auch das Rahmenmodul 30 die gleiche Breite und gleiche Länge wie das Grundgehäusemodul 10 aufweisen, wobei seine Höhe vorzugsweise der Dicke des Wand- bzw. Bodenmaterials des Grundgehäusemoduls 10 entspricht. In gleicher Weise können auch die gleichen Materialien wie für das Grundgehäusemodul 10 verwendet werden. Zur Realisierung einer Verbindung in x- und z-Richtung kann das Rahmenmodul 30 an seinen beiden Stirnflächen jeweils zwei Verbindungsplatten 31 und 32 sowie 33 und 34 aufweisen, die hinsichtlich ihrer Form und Funktionalität der ersten bis vierten Verbindungsplatte 11 bis 14 des Grundgehäusemoduls 10 entsprechen.

Beispielsweise kann das Rahmenmodul 30 an seiner Unterseite eine Aussparung 39 zur Aufnahme des Gehäusedeckels 20 aufweisen, wodurch sich eine besonders kompakte Stapelbarkeit in z-Richtung ergibt und darüber hinaus eine zusätzliche Arretierung in x-Richtung sichergestellt ist. Gemeinsam mit den Klemmlaschen 36 kann dadurch der Gehäusedeckel 20 spielfrei in x-, y- und z-Richtung verklemmt werden.

Das vom Rahmenmodul 30 gehaltene flächige Elektronikbauteil 38 kann beispielsweise eine Ausgabeeinheit in Form einer LCD-Anzeigeeinheit oder eine Eingabeeinheit in Form einer Tastatur aufweisen. Vorzugsweise können so genannte berührungssensitive Anzeigeeinheiten als flächiges Elektronikbauteil 38 verwendet werden, welche sowohl eine Eingabe als auch eine Anzeige ermöglichen. Derartige Ein-/Ausgabeeinheiten sind beispielsweise aus dem Bereich der Smartphones allgemein bekannt. Darüberhinaus können auch akustische Ein-/Ausgabeeinheiten wie z.B. Lautsprecher und/oder Mikrofone verwendet werden. Die Ein-/Ausgabeeinheit dient beispielsweise einem lokalen Auslesen von Daten, einer Konfiguration der Telematikeinheiten und/oder einer Authentisierung.

Gemäß Figur 4 kann im Rahmenmodul 30 vorzugsweise ein Solarpanel als flächiges Elektronikbauteil 38 verbaut sein, um die Energieversorgung für die elektronischen Schaltungen zu gewährleisten und/oder einen Akkumulator zu laden.

Insbesondere für den Fall, dass ein Solarpanel im Rahmenmodul 30 verbaut ist, kann dieses an seiner Unterseite Belüftungsschlitze 37 aufweisen, die eine Belüftung des Solarpanels ermöglichen. Die Belüftungsschlitze 37 können beispielsweise eine Höhe von ca. 0,5mm bis 2mm aufweisen und werden vorzugsweise von den Klemmlaschen 36 sowie von Haltestegen 35 des Rahmenmoduls 30 begrenzt.

Ferner kann das Rahmenmodul 30 derart ausgebildet sein, dass es eine Schrägstellung des Solarpanels bzw. des flächigen Elektronikbauteils 38 ermöglicht. Die Schrägstellung erfolgt hierbei vorzugsweise senkrecht zur Transport- bzw. Fahrtrichtung des Transportcontainers um eine Selbstreinigung des Solarpanels zu ermöglichen. Da die Vertiefungen der Transportcontainer üblicherweise senkrecht zur Fahrtrichtung verlaufen, ermöglicht das Rahmenmodul 30 vorzugsweise eine Schrägstellung des Solarpanels in y-Richtung.

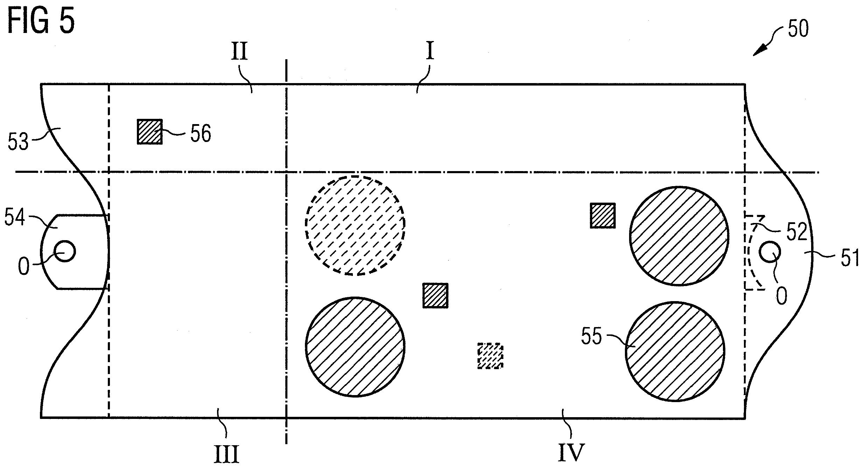

Figur 5 zeigt eine vereinfachte Draufsicht eines Befestigungsmoduls 50, welches eine Befestigung des Gehäusesystems auf einem beliebigen Untergrund ermöglicht. Vorzugsweise dient das Befestigungsmodul 50 zur Realisierung einer Befestigung des Gehäusesystems in einer Vertiefung eines Transportcontainers. Wiederum kann auch das Befestigungsmodul 50 die gleiche Breite und gleiche Länge wie das Grundgehäusemodul 10, bzw. der Gehäusedeckel 20 und das Rahmenmodul 30 aufweisen. In gleicher Weise können auch die gleichen Materialien wie für das Grundgehäusemodul 10 verwendet werden. Zur Realisierung einer Verbindung in x- und z-Richtung kann das Befestigungsmodul 50 wiederum an seinen beiden Stirnflächen jeweils zwei Verbindungsplatten 51 und 52 sowie 53 und 54 aufweisen, die hinsichtlich ihrer Form und Ausgestaltung der ersten bis vierten Verbindungsplatte 11 bis 14 des Grundgehäusemoduls 10 entsprechen.

Das Befestigungsmodul 50 kann beispielsweise eine Vielzahl von Näherungssensoren 56 aufweisen, welche das Erfassen eines Untergrunds ermöglichen. Derartige Näherungssensoren 56 können beispielsweise Ultraschallsensoren, optische Sensoren, kapazitive Sensoren und/oder magnetische Sensoren aufweisen, welche im Befestigunsmodul 50 derart angeordnet sind, dass sie ein Entfernen des Befestigungsmoduls 50 vom Untergrund erfassen. Ferner können mechanische Taster als Näherungssensoren 56 vorgesehen werden. Auf diese Weise kann z.B. ein Alarm ausgelöst und zur zentralen Datenverarbeitungseinheit übermittelt werden, der z.B. ein unauthorisiertes Entfernen (Diebstahl) des Befestigungsmoduls 50 bzw. des daran befestigten Gehäusesystems signalisiert.

Gemäß Figur 5 kann das Befestigungsmodul 50 in vier Quadranten I, II, III und IV aufgeteilt sein, wobei nur in den punktsymmetrisch zueinander angeordneten Quadranten II und IV Näherungssensoren 56 angeordnet sind. Eine derartige Anordnung ermöglicht neben der vorstehend beschriebenen Alarmfunktion zur Signalisierung eines unauthorisierten Entfernens des Befestigungsmoduls 50 ferner eine Signalisierung eines Türzustands (offen/geschlossen). Genauer gesagt kann das Befestigungsmodul 50 derart an einer Tür oder einer festen Wand des Transportcontainers angebracht werden, dass es mit seinem freien Ende (Quadranten II und III) eine (weitere) Tür des Transportcontainers überlappt. Der Näherungssensor 56 im zweiten Quadranten II kann in diesem Fall signalisieren, ob eine Tür des Transportcontainers geöffnet ist. Auf diese Weise kann ein nicht authorisiertes Öffnen des Transportcontainers unmittelbar erfasst und an die Datenverarbeitungseinheit übermittelt und/oder ein lokaler Alarm ausgelöst werden.

Gemäß Figur 5 kann das Befestigungsmodul 50 zumindest ein Befestigungselement 55 aufweisen, welches der Befestigung des Befestigungsmoduls 50 und damit des Gehäusesystems auf dem Untergrund bzw. Transportcontainer dient. Beispielsweise werden als Befestigungselemente 55 Magnete, Saugnäpfe und/oder Klebeelemente verwendet, mit denen das Befestigungsmodul 50 lösbar am Untergrund bzw. Transportcontainer befestigt werden kann. Insbesondere zur Realisierung der Türzustandserfassung werden alle Befestigungselemente 55 nur in einem Quadranten IV angeordnet in dem sich auch die Näherungssensoren für den Diebstahlalarm befinden. Vorzugsweise werden drei oder vier Befestigungselemente im vierten Quadranten IV und zumindest 2 Näherungsensoren 56 angeordnet, wodurch sich eine erhöhte mechanische Stabilität ergibt und die Wahrscheinlichkeit für Fehlalarme verringert ist.

Gemäß Figur 5 sind die Näherungssensoren 56 alle in Querrichtung zueinander versetzt, wodurch auch eine zerklüftete Haftstelle bzw. Untergrund (kleine Sickenstrukturen) zuverlässig darauf geprüft werden können, ob das Modul noch am Untergrund befestigt ist oder nicht. Durch Kombinationsauswertung der Näherungssensoren 56 bzw. Befestigungssensoren kann ein Fehlalarm zuverlässig verhindert werden.

Bei einer derartigen Aufteilung der Befestigungselemente 55 und Näherungsensoren 56 kann das Befestigungsmodul 50 sowohl für horizontal ausgerichtete Türen als auch für vertikal ausgerichtet Türen eines Transportcontainers verwendet werden.

Die Figur 6 zeigt eine vereinfachte perspektivische Ansicht eines Gehäusesystems gemäß einem ersten Ausführungsbeispiel der vorliegenden Erfindung, wobei gleiche Bezugszeichen gleiche oder entsprechende Elemente wie in den Figuren 1 bis 5 bezeichen, weshalb auf eine wiederholte Beschreibung nachfolgend verzichtet wird.

Gemäß Figur 6 ist das Befestigungsmodul 50 beispielsweise in einer (nicht dargestellten) Vertiefung eines Transportcontainers befestigt. Über das aus den jeweiligen Verbindungsplatten bestehende Verbindungssystem sowie das Verriegelungselement 60 können z.B. ein Grundgehäusemodul 10, ein Gehäusedeckel 20 und ein Rahmenmodul 30 mit dem Befestigungsmodul 50 und damit mit dem Transportcontainer verbunden bzw. in z-Richtung gestapelt werden. Ferner ist auch eine (nicht dargestellte) Verlängerung in x-Richtung möglich. Das Gehäusesystem kann folglich eine Vielzahl von unterschiedlichen Gehäusemodulen beliebig miteinander kombinieren, wodurch für jeden Anwendungsfall ein optimales Gehäuse konfigurierbar ist. Die Steckverbindungen sind hierbei äußerst robust und bei der Montage einfach zu handhaben.

Ferner kann gemäß Figur 6 ein Abdeckmodul 40 zur Realisierung eines mechanischen Schutzes vorgesehen sein. Das Abdeckmodul 40 kann hierbei in x- und y-Richtung im Wesentlichen die Abmessungen des Grundgehäusemoduls 10, bzw. des Gehäusedeckels 20 oder des Rahmenmoduls 30 aufweisen, wobei es jedoch keine Verbindungsplatten aufweisen muss, sondern lediglich die zumindest zwei Öffnungen O zum Einführen des Verriegelungselements 60 an geeigneter Stelle besitzt. Vorzugsweise wird für das Abdeckmodul 40 eine durchsichtige Plexiglasscheibe verwendet.

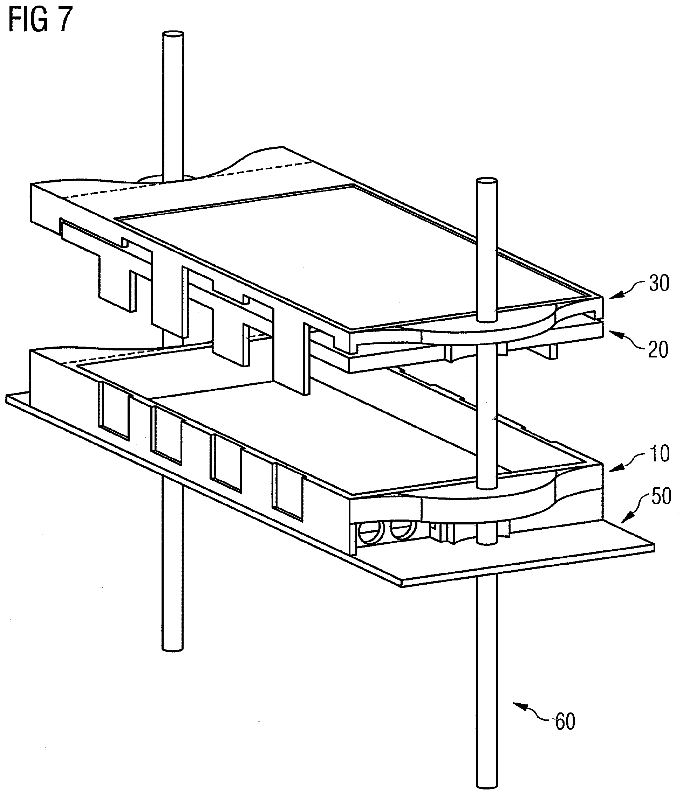

Die Figur 7 zeigt eine vereinfachte perspektivische Ansicht eines Gehäusesystems gemäß einem weiteren Ausführungsbeispiel der vorliegenden Erfindung, wobei gleiche Bezugszeichen gleiche oder entsprechende Elemente wie in den Figuren 1 bis 5 bezeichnen, weshalb auf eine wiederholte Beschreibung nachfolgend verzichtet wird.

Gemäß Figur 7 ist das Befestigungsmodul 50 wiederum in einer (nicht dargestellten) Vertiefung eines Transportcontainers befestigt, wobei es jedoch im Wesentlichen aus einer rechteckigen Befestigungsplatte besteht, die über Nieten, Schrauben oder einer Verklebung fest mit dem Transportcontainer verbunden ist. Das Befestigungsmodul 50 ist in diesem Falle wie das Abdeckmodul 40 des ersten Ausführungsbeispiels als rechteckige Platte mit zumindest zwei Öffnungen ausgestaltet, in die die Verriegelungselemente 60 einführbar sind.

Das Gehäusesystem gemäß Figur 7 kann wiederum eine Vielzahl von unterschiedlichen Gehäusemodulen beliebig miteinander kombinieren, wodurch für jeden Anwendungsfall ein optimales Gehäuse konfigurierbar ist. Das Befestigungsmodul ist hierbei besonders kostengünstig und mit einer geringen Höhe zu realisieren. Das Befestigungsmodul 50 kann beispielsweise die Abmessungen (in x- und y-Richtung) der weiteren Module aufweisen, obwohl es vorzugsweise insbesondere eine Länge aufweist, die dem endgültigen Gehäusesystem entspricht.

Gemäß Figur 7 kann das modulare Gehäusesystem auch ohne Abdeckmodul realisiert werden, wenn ein zusätzlicher mechanischer Schutz nicht notwendig ist.

Die Erfindung wurde vorstehend anhand von bevorzugten Ausführungsbeispielen beschrieben. Sie ist jedoch nicht darauf beschränkt und umfasst insbesondere auch Kombinationen der vorstehend beschriebenen Ausführungsbeispiele. Insbesondere können Grundgehäusemodule mit Gehäusedeckel mehrfach kombiniert werden, wobei auch einzelne Funktionsmodule (Rahmenmodul mit unterschiedlichen Funktionseinheite, Befestigungsmodul, usw.) mehrfach übereinander und/oder nebeneinander angeordnet werden können.

Obwohl erfindungsgemäße halbrunde Verbindungsplatten mit konkaven und konvexen Stirnflächen beschrieben sind, welche jeweils formschlüssig ineinandergreifen, können ebenfalls eckige Formen für die Verbindungsplatten zum Einsatz kommen.

## Patentansprüche

1. Modulares Gehäusesystem zur Aufnahme von elektronischen Schaltungen, insbesondere von Telematikeinheiten, mit zumindest einem Grundgehäusemodul (10), welches zwei gegenüberliegende Stirnflächen aufweist, wobei an der ersten Stirnfläche in einer ersten Ebene eine erste Verbindungsplatte (11) und in einer zweiten von der ersten Ebene unterschiedlichen Ebene eine zweite Verbindungsplatte (12) ausgebildet sind;
an der zweiten Stirnfläche in der ersten Ebene eine dritte Verbindungsplatte (13) und in der zweiten Ebene eine vierte Verbindungsplatte (14) ausgebildet sind, wobei jeweils die erste und dritte Verbindungsplatte (11, 13) sowie die zweite und vierte Verbindungsplatte (12, 14) an ihren Stirnflächen derart ausgeformt sind, dass die dritte und vierte Verbindungsplatte (13) und (14) entsprechend invertierte Formen zu der ersten und zweiten Verbindungsplatte (11) und (12) aufweisen, und
die erste und vierte Verbindungsplatte (11, 14) jeweils zumindest eine Öffnung (O) aufweisen, in die jeweils ein Verriegelungselement (60) einführbar ist,
so dass eine Vielzahl von Grundgehäusemodulen (10) in vertikaler Richtung oder in horizontaler Richtung Form stabil und exakt miteinander verbunden werden können.

2. Modulares Gehäusesystem nach Patentanspruch 1, wobei die erste und vierte Verbindungsplatte (11, 14) jeweils eine konvexe Form und die zweite und dritte Verbindungsplatte (12, 13) jeweils eine konkave Form aufweisen.

3. Modulares Gehäusesystem nach Patentanspruch 1 oder 2, wobei an den Stirnflächen des Grundgehäusemoduls (10) ferner zumindest ein Durchlass (D) zur Realisierung einer elektrischen Steckverbindung und/oder eines Kabeldurchlasses zwischen benachbarten Modulen ausgebildet ist.

4. Modulares Gehäusesystem nach einem der Patentansprüche 1 bis 3, wobei die erste und zweite Verbindungsplatte (11, 12) sowie die dritte und vierte Verbindungsplatte (13, 14) unmittelbar übereinander angeordnet sind.

5. Modulares Gehäusesystem nach einem der Patentansprüche 3 oder 4, wobei zumindest eine der Stirnflächen des Grundgehäusemoduls (10) eine Vertiefung (V) aufweist, in der der zumindest eine Durchlass (D) ausgebildet ist.

6. Modulares Gehäusesystem nach einem der Patentansprüche 1 bis 5, wobei in dem Grundgehäusemodul (10) zumindest eine Aufnahme für einen Akkumulator, ein GPS-Modul, ein Funk-Modul und/oder eine Schaltungsplatine ausgebildet ist.

7. Modulares Gehäusesystem nach einem der Patentansprüche 1 bis 6, wobei das zumindest eine Verriegelungselement (60) eine Steckachse mit kreisrundem, ovalem oder mehreckigem Querschnitt darstellt.

8. Modulares Gehäusesystem nach einem der Patentansprüche 1 bis 7, wobei ferner ein Gehäusedeckel (20) vorgesehen ist, der das Gehäusemodul (10) abdeckt, wobei der Gehäusedeckel (20) an seinen Stirnflächen jeweils nur eine Verbindungsplatte (22, 24) aufweist, die hinsichtlich ihrer Form der zweiten und vierten Verbindungsplatte (12, 14) entspricht.

9. Modulares Gehäusesystem nach Patentanspruch 8, wobei das Grundgehäusemodul (10) an seinen Seitenflächen zumindest eine erste Aussparung (15) aufweist und der Gehäusedeckel (20) zumindest eine zugehörige Klemmlasche (25) aufweist, wobei durch Eingreifen der zumindest einen Klemmlasche (25) in die zumindest eine Aussparung (15) des Grundgehäusemoduls (10) der Gehäusedeckel (20) auf dem Grundgehäusemodul (10) befestigt wird.

10. Modulares Gehäusesystem nach einem der Patentansprüche 1 bis 9, wobei ferner ein Rahmenmodul (30) zur Aufnahme eines flächigen Elektronikbauteils (38) vorgesehen ist, wobei das Rahmenmodul an seinen Stirnflächen jeweils zwei Verbindungsplatten (31, 32, 33, 34) aufweist, die hinsichtlich ihrer Form der ersten bis vierten Verbindungsplatte (11, 12, 13, 14) entsprechen.

11. Modulares Gehäusesystem nach Patentanspruch 10, wobei das Grundgehäusemodul (10) an seinen Seitenflächen ferner zumindest eine zweite Aussparung (16) aufweist und das Rahmenmodul (30) zumindest eine zugehörige Klemmlasche (36) aufweist, wobei durch Eingreifen der zumindest einen Klemmlasche (36) in die zumindest eine Aussparung (16) des Grundgehäusemoduls (10) das Rahmenmodul (30) auf dem Grundgehäusemodul (10) befestigt wird.

12. Modulares Gehäusesystem nach Patentanspruch 10 oder 11, wobei das Rahmenmodul (30) ferner eine Aussparung (39) zur Aufnahme des Gehäusedeckels (20) aufweist.

13. Modulares Gehäusesystem nach einem der Patentansprüche 10 bis 12, wobei das flächige Elektronikbauteil (38) eine Ausgabeeinheit und/oder eine Eingabeeinheit darstellt.

14. Modulares Gehäusesystem nach einem der Patentansprüche 10 bis 12, wobei das flächige Elektronikbauteil (38) ein Solarpanel aufweist und das Rahmenmodul (30) ferner Belüftungsschlitze (37) zum Belüften des Solarpanels aufweist.

15. Modulares Gehäusesystem nach nach einem der Patentansprüche 1 bis 14, wobei ferner ein Abdeckmodul (40), insbesondere eine Plexiglasscheibe, zur Realisierung eines mechanischen Schutzes vorgesehen ist, das zumindest zwei Öffnungen (O) aufweist, in die jeweils das Verriegelungselement (60) einführbar ist.

## Claims

1. Modular housing system for accommodating electronic circuits, in particular telematics units, said modular housing system having at least one basic housing module (10) which comprises two oppositely located end faces, wherein
a first connecting plate (11) is realized in a first plane on the first end face and a second connecting plate (12) is realized in a second plane which is different from the first plane;
a third connecting plate (13) is realized in the first plane on the second end face and a fourth connecting plate (14) is realized in the second plane, wherein
in each case the first and third connecting plate (11, 13) as well as the second and fourth connecting plate are formed on their end faces in such a manner that the third and fourth connecting plate (13) and (14) comprise forms which are correspondingly inverted with respect to the first and second connecting plate (11) and (12), and
the first and fourth connecting plate (11, 14) comprise in each case at least one opening (O) into which in each case a locking element (60) can be introduced,
so that a plurality of basic housing modules (10) can be connected together in a vertical direction or in a horizontal direction in a sturdy and precise manner.

2. Modular housing system according to Claim 1, wherein the first and fourth connecting plate (11, 14) comprise in each case a convex form and the second and third connecting plate (12, 13) comprise in each case a concave form.

3. Modular housing system according to Claim 1 or 2, wherein, in addition, at least one passage (D) is realized between adjacent modules on the end faces of the basic housing module (10) for realizing an electric plug connection and/or a cable duct.

4. Modular housing system according to one of Claims 1 to 3, wherein the first and second connecting plate (11, 12) as well as the third and fourth connecting plate (13, 14) are arranged directly one above the other.

5. Modular housing system according to either of Claims 3 or 4, wherein at least one of the end faces of the basic housing module (10) comprises an indentation (V) in which the at least one passage (D) is realized.

6. Modular housing system according to one of Claims 1 to 5, wherein at least one accommodating means for an accumulator, a GPS module, a radio module and/or a printed circuit board is realized in the basic housing module (10).

7. Modular housing system according to one of Claims 1 to 6, wherein the at least one locking element (60) provides a thru shaft with a circular, oval or polygonal cross section.

8. Modular housing system according to one of Claims 1 to 7, wherein there is additionally provided a housing cover (20) which covers the housing module (10), wherein, on its end faces, the housing cover (20) comprises in each case only one connecting plate (22, 24) which, with regard to its form, corresponds to the second and fourth connecting plate (12, 14).

9. Modular housing system according to Claim 8, wherein the basic housing module (10) comprises on its side faces at least one first recess (15) and the housing cover (20) comprises at least one associated clamping bracket (25), wherein the housing cover (20) is fastened on the basic housing module (10) as a result of engaging the at least one clamping bracket (25) in the at least one recess (15) of the basic housing module (10).

10. Modular housing system according to one of Claims 1 to 9, wherein in addition a frame module (30) is provided for accommodating a flat electronic component (38), wherein the frame module comprises on its end faces in each case two connecting plates (31, 32, 33, 34) which, with regard to their form, correspond to the first to fourth connecting plate (11, 12, 13, 14).

11. Modular housing system according to Claim 10, wherein the basic housing module (10) additionally comprises on its side faces at least one second recess (16) and the frame module (30) comprises at least one associated clamping bracket (36), wherein the frame module (30) is fastened on the basic housing module (10) as a result of engaging the at least one clamping bracket (36) in the at least one recess (16) of the basic housing module (10) .

12. Modular housing system according to Claim 10 or 11, wherein the frame module (30) additionally comprises a recess (39) for accommodating the housing cover (20).

13. Modular housing system according to one of Claims 10 to 12, wherein the flat electronic component (38) provides an output unit and/or an input unit.

14. Modular housing system according to one of Claims 10 to 12, wherein the flat electronic component (38) comprises a solar panel and the frame module (30) additionally comprises ventilating slots (37) for venting the solar panel.

15. Modular housing system according to one of Claims 1 to 14, wherein there is additionally provided a cover module (40), in particular a Plexiglas sheet, for realizing mechanical protection which comprises at least two openings (O) into which in each case the locking element (60) can be introduced.

## Revendications

1. Système de boîtier modulaire, destiné à recevoir des circuits électroniques, en particulier des unités télématiques, comprenant au moins un module de boîtier de base (10) qui comporte deux faces d'extrémité opposées, une première plaque de connexion (11) étant formée dans un premier plan sur la première face d'extrémité et une deuxième plaque de connexion (12) étant formée dans un deuxième plan différent du premier plan ;
une troisième plaque de connexion (13) étant formée dans le premier plan, et une quatrième plaque de connexion (14) étant formée dans le deuxième plan, sur la deuxième face d'extrémité, les première et troisième plaques de connexion (11, 13) ainsi que les deuxième et quatrième plaques de connexion (12, 14) étant conçues, au niveau de leurs faces d'extrémité, de telle sorte que les troisième et quatrième plaques de connexion (13) et (14) ont des formes inversées correspondantes par rapport aux première et deuxième plaques de connexion (11) et (12), et les première et quatrième plaques de connexion (11, 14) comportent chacune au moins une ouverture (O) dans laquelle un élément de verrouillage (60) peut être inséré de sorte qu'une pluralité de modules de boîtier de base (10) peuvent être reliés entre eux de manière stable et précise dans la direction verticale ou dans la direction horizontale.

2. Système de boîtier modulaire selon la revendication 1, les première et quatrième plaques de connexion (11, 14) ayant chacune une forme convexe et les deuxième et troisième plaques de connexion (12, 13) ayant chacune une forme concave.

3. Système de boîtier modulaire selon la revendication 1 ou 2, au moins un passage (D) destiné à réaliser une liaison enfichable électrique et/ou un passage de câble entre des modules adjacents étant formé au niveau des faces d'extrémité du module de boîtier de base (10).

4. Système de boîtier modulaire selon l'une des revendications 1 à 3, les première et deuxième plaques de connexion (11, 12) et les troisième et quatrième plaques de connexion (13, 14) étant disposées directement les unes sur les autres.

5. Système de boîtier modulaire selon l'une des revendications 3 ou 4, au moins une des faces d'extrémité du module de boîtier de base (10) comportant une cavité (V) dans laquelle est formé au moins un passage (D).

6. Système de boîtier modulaire selon l'une des revendications 1 à 5, au moins un logement destiné à recevoir une batterie rechargeable, un module GPS, un module radio et/ou une carte de circuit imprimé étant formés dans le module de boîtier de base (10).

7. Système de boîtier modulaire selon l'une des revendications 1 à 6, l'au moins un élément de verrouillage (60) constituant un axe d'enfichage de section transversale circulaire, ovale ou polygonale.

8. Système de boîtier modulaire selon l'une des revendications 1 à 7, un couvercle de boîtier (20) étant en outre prévu qui recouvre le module de boîtier (10), le capot de boîtier (20) ne comportant au niveau de chacune de ses faces extrémité qu'une seule plaque de connexion (22, 24) qui correspond, en termes de forme, aux deuxième et quatrième plaques de connexion (12, 14).

9. Système de boîtier modulaire selon la revendication 8, le module de boîtier de base (10) comportant au moins un premier évidement (15) au niveau de ses faces latérales et le couvercle de boîtier (20) comportant au moins une patte de serrage associée (25), le couvercle de boîtier (20) étant fixé sur le module de boîtier de base (10) par engagement de l'au moins une patte de serrage (25) dans l'au moins un évidement (15) du module de boîtier de base (10).

10. Système de boîtier modulaire selon l'une des revendications 1 à 9, un module formant cadre (30) étant en outre prévu pour recevoir un composant électronique (38) sensiblement bidimensionnel, le module formant cadre comportant au niveau de chacune de ses faces d'extrémité deux plaques de connexion (31, 32, 33, 34) qui correspondent, en termes de forme, aux première à quatrième plaques de connexion (11, 12, 13, 14) .

11. Système de boîtier modulaire selon la revendication 10, le module de boîtier de base (10) comprenant en outre, au niveau de ses faces latérales, au moins un deuxième évidement (16) et le module formant cadre (30) comportant au moins une patte de serrage associée (36), le module formant cadre (30) étant fixé sur le module de boîtier de base (10) par engagement de l'au moins une patte de serrage (36) dans l'au moins un évidement (16) du module de boîtier de base (10).

12. Système de boîtier modulaire selon la revendication 10 ou 11, le module formant cadre (30) comprenant en outre un évidement (39) destiné à recevoir le couvercle de boîtier (20).

13. Système de boîtier modulaire selon l'une des revendications 10 à 12, le composant électronique (38) sensiblement bidimensionnel constituant une unité de sortie et/ou une unité d'entrée.

14. Système de boîtier modulaire selon l'une des revendications 10 à 12, le composant électronique (38) sensiblement bidimensionnel comportant un panneau solaire et le module formant cadre (30) comportant d'autres fentes d'aération (37) destinées à ventiler le panneau solaire.

15. Système de boîtier modulaire selon l'une des revendications 1 à 14, **caractérisé en ce qu'**il est prévu un module de recouvrement (40), en particulier une plaque de plexiglas, qui est destiné à réaliser une protection mécanique et qui comporte au moins deux ouvertures (O) dans chacune desquelles l'élément de verrouillage (60) peut être inséré.
